(19) Europäisches Patentamt
European Patent Office
Office européen des brevets

(11) **EP 4 456 156 A1**

(12) **EUROPEAN PATENT APPLICATION**

(43) Date of publication:
**30.10.2024 Bulletin 2024/44**

(21) Application number: **23169898.6**

(22) Date of filing: **25.04.2023**

(51) International Patent Classification (IPC):
**H01L 31/18** (2006.01)     **H01L 31/078** (2012.01)

(52) Cooperative Patent Classification (CPC):
**H01L 31/1804; H01L 31/078; H10K 30/57; H10K 39/15; H10K 85/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Nederlandse Organisatie voor toegepast-natuurwetenschappelijk Onderzoek TNO**
**2595 DA 's-Gravenhage (NL)**

(72) Inventors:
• **GEERLIGS, Lambert Johan**
**2595 DA 's-Gravenhage (NL)**
• **VEENSTRA, Siegfried Christiaan**
**2595 DA 's-Gravenhage (NL)**
• **VAN DEN BRUELE**
**2595 DA 's-Gravenhage (NL)**

(74) Representative: **V.O.**
**P.O. Box 87930**
**2508 DH Den Haag (NL)**

(54) **TANDEM SOLAR CELL AND METHOD OF MANUFACTURING THE SAME**

(57)     The present disclosure provides a method of manufacturing a tandem solar cell (1) comprising a stack of at least a rear photovoltaic component (1R) and a front photovoltaic component (1F) between a front electrode (215) facing a light entry window (211) and a rear electrode (225). The tandem solar cell (1) to be manufactured therewith is configured to perform a photovoltaic conversion of light received through the light entry window (211) to provide an output voltage between the electrodes. The front photovoltaic component (1F) is configured to convert a first portion of the received light and the rear photovoltaic component (1R) is configured to convert a second portion of the received light that is transmitted by the front photovoltaic component (1F). The stack includes a substrate (23) with a first side (231) facing the light entry window (211) and a second side (232) facing away from the light entry window (211). The method comprises providing (S1) the substrate (23), depositing (S3R, S3B, S3F) functional layers on the substrate (23). In particular the method comprises one or more bilateral deposition steps (S3B) wherein a substance is simultaneously deposited at both sides of the substrate.

FIG. 1A

FIG. 1B

**Description**

BACKGROUND

The present application pertains to a tandem solar cell.

The present application further pertains to a method of manufacturing a tandem solar cell.

A tandem solar cell comprises two or more photovoltaic cells stacked on top of each other. The photovoltaic cells are configured to provide for photovoltaic conversion in mutually different ranges of the solar spectrum so that solar energy can be converted more efficiently into electrical energy. A common type of tandem solar cell comprises a combination of a silicon based photovoltaic cell and a perovskite based photovoltaic cell. In this combination the perovskite based cell is typically arranged on top, i.e. at the light receiving side of the tandem solar cell and the silicon based cell is arranged behind the perovskite based cell. Therein the perovskite based cell absorbs light in the visible range and the silicon based cell absorbs light in the near-infrared range, which is not absorbed by the perovskite based cell.

Manufacturing a solar cell requires various processing steps. This is in particular the case for tandem solar cells. For the purpose of minimizing manufacturing costs there is a need to reduce the number of process steps and reduce their individual cost.

SUMMARY

According to a first aspect of the present application an improved method of manufacturing a tandem solar cell is provided.

Therewith a tandem solar cell is obtained according to the second aspect of the invention that comprises a stack of at least a rear photovoltaic cell and a front photovoltaic cell, the front photovoltaic cell being arranged between the rear photovoltaic cell and a light receiving side of the tandem solar cell, therewith defining a reference direction from the rear photovoltaic cell via the front photovoltaic cell, the front photovoltaic cell being arranged between the rear photovoltaic cell and a light receiving side.

Embodiments of the improved method comprise:

providing a substrate having mutually opposite sides;
depositing functional layers on the substrate.

Deposition may take place in various ways. Exemplary deposition methods are Physical Vapor Deposition (PVD, with a variety of implementations such as thermal evaporation), Chemical Vapor Deposition (CVD), sputtering (which is a specific variety of PVD), and Atomic Layer Deposition (ALD). Each of these deposition methods have respective advantages and disadvantages. Physical Vapor Deposition (PVD) is suitable for deposition of a wide range of materials, including metals and ceramics such as oxides with a high purity and density and can be used to create complex multilayer structures. Also this approach is advantageous in that it provides for a good adhesion between layers.

Deposition at a high deposition rate and a good film uniformity can be achieved with Chemical Vapor Deposition (CVD). Also CVD is applicable for a wide range of materials, including metals, semiconductors, and ceramics such as oxides. The CVD approach is applicable at low temperatures, which is particularly useful for temperature-sensitive substrates.

Sputtering is also suitable for deposition of a wide range of materials at a high deposition rate while having a good control over film thickness and composition. Sputtering is known to often result in atomic-scale damage to the substrate, e.g. by the deep UV radiation created in the sputter process conditions, or by the impact energy of the deposited species. Such defects can result in reduced performance of a photovoltaic device based on the substrate.

Atomic Layer Deposition (ALD) allows a very precise control over film thickness and composition. Even on complex surfaces a uniform film deposition is possible. Compared to sputtering, deposition is less prone to causing much damage to a substrate.

Numerous other deposition techniques are available such as printing, e.g. ink-jet printing, screen printing, spraying and spin coating.

The improved method as claimed herein comprises at least one bilateral deposition step wherein a substance is simultaneously deposited at both sides of the substrate. Some deposition techniques, such as ALD may be relatively slow. By simultaneous deposition of a substance at both sides of the substrate a significant improvement in manufacturing efficiency is achieved.

The bilateral deposition step can be advantageously performed in a batch deposition process wherein deposition is performed on a plurality of substrates. In some embodiments the substance deposited therewith forms a selective charge carrier layer on one side of the substrate. In some embodiments the layer formed on the other side, further also denoted as "simultaneously formed layer" may not have an specific function. In these embodiments the specifications of the simultaneously formed layer are not relevant, for example the simultaneously formed layer may have a non-uniform thickness. Alternatively the layer formed on the other side of the substrate the substance may have a particular functionality as set out below. In that case it is desirable that the batch deposition process is designed to deposit the layers on both sides in a substantially uniform manner with substantially the same thickness. In any case, typically the layers that are simultaneously formed on both sides have substantially the same composition. Also in case that the simultaneously deposited layer does not have a proper functionality, the batch process to perform the bilateral deposition step is still efficient as it is not necessary to remove the simultaneously deposited layer. The improved method may further comprise surface modification techniques, such as etching, application of a Self-Assembled Monolayer (SAM), ion implantation, plasma treatment, heat treatment, and the like.

It is noted that in accordance with the generally accepted interpretation the wording "tandem" denotes "a group of two or more arranged one behind the other or used or acting in conjunction". Accordingly a tandem solar cell may comprise in addition to the front photovoltaic cell and the rear photovoltaic cell one or more further photovoltaic cells.

In an embodiment of the method the rear photovoltaic cell is silicon based. The silicon based cell is particularly suitable for photo-electric conversion of light in the near-infrared range. In an example of this embodiment the substrate is a silicon wafer. A silicon wafer, e.g. having a thickness in the range of 50-200 $\mu$m is very suitable as a basis for forming the silicon based cell and for performing the further processing steps to form the front photovoltaic cell.

In an embodiment of the method the front photovoltaic cell is perovskite based. Perovskite based photovoltaic cells having a high photo-electric conversion efficiency are available. In particular a combination of a perovskite based photovoltaic cell and a silicon based photovoltaic cell is advantageous as the absorption bands of these cells may complement each other in that the perovskite based cell absorbs light in the visible range and the UV-range and the silicon based cell absorbs light in the near-infrared range, which is not absorbed by the perovskite based cell. Another embodiment of the method comprises manufacturing a tandem solar cell wherein both the front photovoltaic cell and the rear photovoltaic cell are perovskite based, wherein the perovskite of the front photovoltaic cell has a larger (wider) bandgap than the perovskite of the rear photovoltaic cell. Again another embodiment of the method comprises manufacturing a tandem solar cell comprising a perovskite based front photovoltaic cell and a CIGS-based rear photovoltaic cell.

In an embodiment of the method the substance being deposited in a bilateral deposition step of the one or more bilateral deposition steps forms at the front side of the substrate a layer having a selective charge carrier transport functionality ('selective' meaning: transporting preferentially electrons or holes, preferentially meaning many more carriers of one type than of the other type, from the absorber material of the front photovoltaic cell, e.g. a perovskite, towards the external contacts, and often also preventing to a certain extent recombination of electrons and holes generated in the absorber material at the surface of the absorber material closest to this layer.). In the following we will refer to 'a layer having a selective charge carrier transport functionality' as 'a charge carrier transport layer' or 'layer having a charge carrier transport functionality'. In an example thereof the layer having a charge carrier transport layer functionality is formed at a side of the absorber layer of the front photovoltaic component facing the light entry window. In another example additionally or alternatively the layer having a charge carrier transport layer functionality is formed at a rear side of the absorber layer of the front photovoltaic component facing away from the light entry window. It is noted that the wording "absorber layer" is conventionally used to denote the layer where photon radiation is absorbed for the purpose of photovoltaic conversion.

A suitable charge carrier transport layer material for holes typically has

i) a valence band edge position relative to vacuum level similar to the valence band edge relative to vacuum level of the absorber material of the photovoltaic cell (e.g. aligning within better than 0.35 eV, preferably better than 0.2 eV);
ii) a wide optical band gap such as 2eV or more (preferably more than 2.5 eV, or even more than 3 eV);
iii) a Fermi level close to the valence band edge.

Alternatively, a suitable charge carrier transport layer material for holes may have

i) a conductance band edge position relative to vacuum level similar to the valence band edge relative to vacuum level of the absorber material of the photovoltaic cell;
ii) a wide optical band gap such as 2eV or more (preferably more than 2.5 eV, or even more than 3 eV);
iii) a Fermi level close to the conductance band edge (e.g. Fermi level aligning with valence band edge of the absorber material within better than 0.35 eV, preferably better than 0.2 eV).

A suitable charge carrier transport layer material for electrons typically has

i) a conductance band edge position relative to vacuum level (electron affinity) similar to the conductance band edge relative to vacuum level of the absorber material of the photovoltaic cell (e.g. aligning within better than 0.35 eV, preferably better than 0.2 eV);

ii) a wide optical band gap such as 2eV or more (preferably more than 2.5 eV, or even more than 3 eV);

iii) a Fermi level close to the conductance band edge.

As noted above, in a bilateral deposition step of the improved method the substance is simultaneously deposited at both sides of the substrate. In an embodiment the substance therewith forms at the rear side of the substrate an intermediate layer between the substrate and the rear electrode. The substance present in the intermediate layer can improve a selective extraction of charge carriers from the rear photovoltaic cell. For example, it can improve the selectivity of charge carrier extraction from the rear photovoltaic cell by reducing electron-hole recombination or reducing series resistance of the cell. Hence in this example the bilateral deposition step simultaneously results in providing a charge carrier transport layer for the front photovoltaic cell and an intermediate layer to improve a selective extraction of charge carriers from the rear photovoltaic cell. As an intermediate layer it can also be beneficial in providing protection against deposition damage of the subsequent deposition of the rear electrode. In an embodiment alternatively or additionally the substance being deposited in a bilateral deposition step of the one or more bilateral deposition steps forms at the rear side of the substrate a layer covering the rear electrode. The layer covering the rear electrode therewith can serve as a moisture protection layer for the rear electrode. Hence in this example the bilateral deposition step simultaneously results in providing a charge carrier transport layer for the front photovoltaic cell and a moisture protection layer for the rear electrode.

It has been found that NiO is particularly suitable for use in the bilateral deposition step to simultaneously form a hole transport layer for the front photovoltaic cell and to form an intermediate layer that enhances hole extraction from the rear photovoltaic cell or a moisture protection layer for the rear electrode. In second example, it has been found that $SnO_2$ and $TiO_2$ are particularly suitable for use in the bilateral deposition step to simultaneously form an electron transport layer for the front photovoltaic cell and to form a moisture protection layer for the rear electrode.

In other embodiments, a material deposited in the bilateral deposition step is suitable to simultaneously form a charge carrier transport layer for the front photovoltaic cell and on the rear either an intermediate layer that enhances selective carrier extraction from the rear photovoltaic cell or a moisture protection layer for the rear electrode but not both. For example, in a third example, it has been found that ZnO or Al-doped ZnO (AZO) is particularly suitable for use in the bilateral deposition step to simultaneously form an electron transport layer for the front photovoltaic cell and to form an intermediate layer that enhances electron extraction from the rear photovoltaic cell.

Many elements and approaches for doping of ZnO and $SnO_2$ are known. Further examples of materials that may be deposited via ALD may use $Cu_2O$, CuI (via chemical conversion of ALD-CuO), $MoO_3$ or $WO_3$ or $V_2O_3$ for hole transport layer, or $TiO_2$, $Ta_2O_5$, $Nb_2O_5$, TiN, $TaN_x$, $In_2S_3$, $MoS_2$, for electron transport layer, if the alignment to the energy bands of the absorber layer is suitable.

Alignment of energy bands between charge carrier transport layer and absorber layer may be further improved by materials or layers at the interface, such as materials that create an electrical interface dipole, such as chemical additives or monolayers at the interface. The energy levels can be determined with photoelectron spectroscopy. Generally speaking the energy levels between mutually adjacent layers, such as a charge carrier transport layer and a photo-electric conversion layer (absorber layer) should not differ more than 0.35 eV, to avoid undue Voc-losses and/or FF-losses, and preferably the energy level differences between adjacent layers is limited to about 0.2 eV.

A charge carrier transport layer typically has a sheet resistance of at least 200 Ohm, preferably even at least 1000 Ohm.

The selective carrier extraction functionality of a charge carrier transport layer can sometimes be improved by combining it with other layers, for example to influence the electrical interface dipoles or defect states at the interface with the absorber layer, or by combining it with a further layer that has even better alignment with the energy band of the absorber layer.

The bilateral deposition step comprises simultaneously depositing a layer having a thickness in the range of 3-50 nm at each side of the substrate, and more preferably a thickness in the range of 3-20 nm. The thickness may be non-uniform over the substrate area on one or both substrate sides. On the rear side, the substrate area may not even be covered fully if the moisture protection is not an important benefit. $SnO_2$, as an example, efficiently protects the electrode of the rear photovoltaic cell against moisture, while, when being provided in a relatively thin layer as is the case here have a good electrical conductivity. By protecting the electrode of the rear photovoltaic cell against moisture a wider range of rear electrode materials is applicable, including moisture sensitive electrode materials. Therewith more expensive electrode materials, like indium tin oxide (ITO) can be replaced with alternative electrodes of alternative materials like doped zinc oxide (ZnO), for example ZnO:Al.

In an embodiment of the method a charge carrier transport layer formed in a bilateral deposition step is an electron transport layer. In an example thereof the bilateral deposition step comprises simultaneously depositing a layer of $SnO_2$ having a thickness in the range of 3-50 nm at each side of the substrate. The $SnO_2$ layer at the side of the substrate facing the light entry window serves as an electron transport layer. The $SnO_2$ layer that is simultaneously formed at side of the substrate facing away from the light entry window may serve as a protection layer for the rear electrode or as an intermediate layer. Other examples of materials for this purpose are TiO2 and NiOx.

It is particularly advantageous if the method applied in a bilateral deposition step is ALD. ALD is very suitable for controllably depositing thin layers without much damage to underlying layers and by applying this method for simultaneous two-sided deposition, a significant improvement of efficiency or stability is achieved.

The at least one bilateral deposition step may be one of a plurality of bilateral deposition steps. For example, the method comprises a first bilateral deposition step and a second bilateral deposition step. For example in a first bilateral deposition step a charge carrier transport layer of one type (i.e., for electrons or holes) is formed at a side of the absorber layer of the front photovoltaic cell facing away from the light entry window, and in a subsequent bilateral deposition step a carrier transport layer of the opposite type (i.e., for holes or electrons, respectively) is formed at a side of the absorber layer of the front photovoltaic cell facing towards the light entry window. The layer that in the first bilateral deposition step is simultaneously formed at the side of the substrate facing away from the light entry window may serve as a protection layer for the rear electrode. Alternatively or additionally the layer that in the subsequent bilateral deposition step is simultaneously formed at the side of the substrate facing away from the light entry window may serve as a protection layer for the rear electrode. The layer that in the first bilateral deposition step is simultaneously formed at the side of the substrate facing away from the light entry window may enhance selective carrier extraction from the rear photovoltaic cell.

The improved tandem solar cell according to the second aspect of the invention comprises a stack of at least a rear photovoltaic cell and a front photovoltaic cell between a front electrode facing a light entry window and a rear electrode. The improved tandem solar cell is configured to perform a photovoltaic conversion of light received through the light entry window to provide an output voltage between the electrodes. The front photovoltaic cell is configured to convert a first portion of the received light and the rear photovoltaic cell is configured to convert a second portion of the received light that is transmitted by the front photovoltaic cell. The stack includes a substrate that forms the absorber layer of the rear photovoltaic cell with a first side facing the light entry window and a second side facing away from the light entry window. The tandem solar cell comprises one or more pairs of layers, each of said one or more pairs of layers comprising a respective front side layer at a side of the substrate facing the light entry window and a respective rear side layer at a side of the substrate facing away from the light entry window, which respective layers of a pair have substantially the same composition and thickness. The respective functional layers which have substantially the same composition can be deposited in a single bilateral deposition step. Therewith the tandem solar cell is improved in that it can be manufactured relatively efficiently. Due to the fact that the respective functional layers are deposited simultaneously in the bilateral deposition step they have substantially the same composition.

In case a composite material is deposited in the bilateral deposition process, minor deviations may occur in the composition of the pair of layers. Presuming that the material to be deposited comprises components k, then typically, the concentration $c_{kf}$ of each component in the front one of the layers, is substantially the same as the concentration $c_{kr}$ of that component in the corresponding rear one of the layers. That is to say that for each of the cells the respective concentrations comply with the following relationship:

$$r_k = \frac{|c_{kR} - c_{kF}|}{c_{kR} + c_{kF}} < 0.1$$

Typically the ratio $r_k$ as defined herein may be even substantially smaller when the pair of layers has been deposited simultaneously in a bilateral ALD process. For example the ratio $r_k$ in such cases is smaller than 0.05.

Typically the layers deposited in the bilateral deposition step also have the same thickness.

Nevertheless minor deviations may occur due to the fact that the surfaces where deposition takes place in the bilateral deposition step are at mutually opposite sides of the substrate. In view thereof the wording substantially the same thickness is defined as follows. A rear side layer having a thickness $d_R$ and a front side layer having a thickness $d_F$ are considered to have substantially the same thickness if the following requirement is met:

$$r = \frac{|d_R - d_F|}{d_R + d_F} < 0.2$$

Typically the ratio r as defined herein is even substantially smaller when the pair of layers has been deposited simultaneously in a bilateral ALD process. For example the ratio r in such cases is smaller than 0.1 or even smaller than 0.05.

In an example a mean value of the thicknesses of the respective layers of a pair of layers is selected in the range of 3-50 nm, and more preferably in the range 3-30 nm.

In some examples a substrate area on the rear side of the tandem solar cell may not be covered fully with the rear one of the layers, or not fully with specifications of the rear one of the layers according to the above formulas. Also in this example, the tandem solar cell is a product having the advantage that it can be efficiently manufactured in that it can be manufactured using a batch deposition process for simultaneously depositing the pair of layers without requiring a step of removing one of the pair of layers.

In an embodiment of the tandem solar cell the substrate of the rear photovoltaic cell is silicon based. The silicon based rear photovoltaic cell is particularly suitable to convert light of longer wavelengths into electric energy. In this embodiment it is particularly advantageous if the substrate is a silicon wafer. The silicon wafer forms part of the rear photovoltaic cell and it serves as the basis for manufacturing the front photovoltaic cell.

In an embodiment, preferably in combination with a silicon based rear photovoltaic cell the front photovoltaic cell is perovskite based. The class of perovskites is very suitable as the bandgap of the photovoltaic cell based thereon can be tuned to a desired value by the exact choice of the composition of the perovskite material. In a combination with a silicon based rear photovoltaic cell the perovskite based front photovoltaic cell is typically tuned to have a relatively large (wide) bandgap, so as to be configured to convert light in the relatively short wavelength part and to transmit light having longer wavelengths for conversion by the silicon based rear photovoltaic cell. Alternatively, the rear photovoltaic cell may be CIGS-based or may also be perovskite based.

It is noted that the invention is not restricted to (manufacturing of) tandem solar cells having two photovoltaic cells. For example one or more additional photovoltaic cells may be provided between the front photovoltaic cell and the rear photovoltaic cell.

BRIEF DESCRIPTION OF THE DRAWINGS

These and other aspects are described in more detail with reference to the drawings. Therein:

FIG. 1A schematically shows an embodiment of an improved tandem solar cell and FIG. 1B shows an example thereof in more detail;
FIG. 2A schematically shows a further embodiment of an improved tandem solar cell and FIG. 2B shows an example thereof in more detail;
FIG. 2C and FIG. 2D show still further embodiments;
FIG. 3A, 3B and 3C show examples of other further embodiments of the improved tandem solar cell;
FIG. 4A and 4B show alternative embodiments and FIG. 4C shows an example of the embodiment of FIG. 4A in more detail; FIG. 4D shows another example in more detail; FIG. 4E shows a still further embodiment;
FIG. 5A, 5B show exemplary components for use in the embodiments of FIG. 4A - 4D;
FIG. 6 schematically shows an embodiment of an improved method.

While all drawings show front and rear cells which have charge extraction of p-type polarity on the rear and n-type polarity on the front, the invention is similarly applicable to front and rear cells which have charge extraction of n-type polarity on the rear and p-type polarity on the front. For electrical series connection of the front and rear cell in a monolithic structure, which is the subject of this invention, the polarity of the charge extraction on the front of the rear cell, and the polarity of the charge extraction on the rear of the front cell, are opposite to each other.

DETAILED DESCRIPTION OF EMBODIMENTS

Like reference symbols in the various drawings indicate like elements unless otherwise indicated.

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.

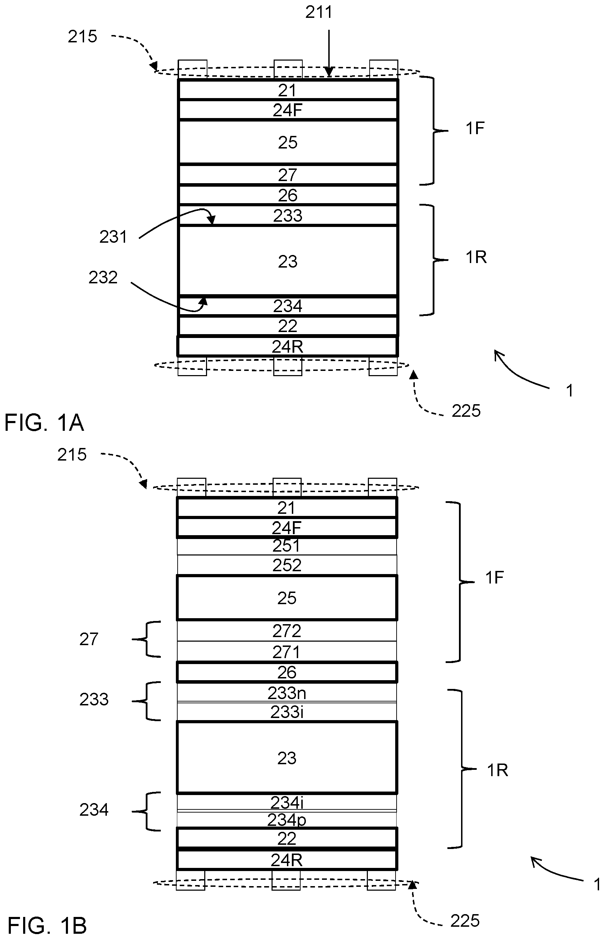

FIG. 1A schematically shows a cross section of a tandem solar cell 1 comprising a stack of at least a rear photovoltaic cell 1R and a front photovoltaic cell 1F between a front electrode 21 facing a light entry window 211 and a rear electrode 22. The tandem solar cell 1 is configured to perform a photovoltaic conversion of light received through the light entry window 211 to provide an output voltage between the electrodes 21, 22. The front photovoltaic cell 1F is configured to convert a first portion of the received light and the rear photovoltaic cell 1R is configured to convert a second portion of the received light that is transmitted by the front photovoltaic cell 1F. The stack includes a substrate 23 with a first side 231 facing the light entry window 211 and a second side 232 facing away from the light entry window 211. The tandem solar cell 1 comprises at each side of the substrate 23 a respective layer 24F, 24R. These layers 24F, 24R have substantially the same composition and thickness. In the example shown in FIG. 1A the rear photovoltaic cell 1R is silicon based, in that the substrate 23 is a silicon wafer. The front photovoltaic cell 1F is perovskite based in that it comprises a perovskite absorber layer 25. The silicon based rear photovoltaic cell 1R comprises a first silicon heterojunction 233 at its first side 231 facing the light entry window 211 and comprises a second silicon heterojunction 234 at its second side 232 facing away from the light entry window 211. In the example shown the tandem solar cell 1 further comprises a recombination layer 26 between the rear photovoltaic cell 1R and the front photovoltaic cell 1F. At each side a respective metallization grid 215, 225 is provided for providing an electric contact with a respective one of the electrodes 21, 22. The perovskite based front photovoltaic cell 1F comprises a first charge carrier transport layer 24F at a side of the absorber layer 25 facing the light entry window 211 and a second charge carrier transport layer 27 at a side of the absorber layer 25 facing away from the light entry window 211. The layer 24R having substantially the same composition and thickness as the first charge carrier transport layer 24F is provided as a protection against moisture over a surface of the second electrode 22. It is noted that the tandem photovoltaic cell 1 may include further layers in addition to those mentioned above, as is illustrated in the example of FIG. 1B. It also noted that 24F may be one layer in a layer stack that functions as a whole as charge carrier transport layer.

In the example of FIG. 1B, the substrate 23 is formed by a silicon wafer having a thickness in the range of 50-200 μm. The first silicon heterojunction 233 is formed by an intrinsic sublayer 233i of H-enriched amorphous (a-Si:H) having a thickness in the range of 1-10 nm and an n-type sublayer 233n of H-enriched amorphous (a-Si:H) having a thickness in the range of 5-20 nm. The intrinsic sublayer 233i is provided between the silicon wafer 23 and the n-type layer 233n. The second silicon heterojunction 234 is formed by an intrinsic sublayer 234i of H-enriched amorphous (a-Si:H) having a thickness in the range of 1-10 nm and a p-type sublayer 234p of H-enriched amorphous (a-Si:H) having a thickness in the range of 5-20 nm. The intrinsic sublayer 234i is provided between the silicon wafer 23 and the p-type sublayer 234p. The sublayers of the first and the second heterojunctions typically have been deposited with a PECVD process. Other silicon heterojunctions as known in the art may be used, such as comprising nanocrystalline or polycrystalline Si, SiOx, SiCx, etc. Also, other passivated contacts may be used, such as where 233i and 234i are replaced by a thin dielectric buffer layer such as silicon oxide or silicon oxynitride, sufficiently thin and/or porous to transport charge carriers, and where 233n and 234p are replaced by a doped layer of substantially polycrystalline silicon. Also, other electron and hole contacts may be used, such as where layer 233 includes a diffused or implanted or deposited n-type silicon region in or on the wafer, and layer 234 includes a diffused or implanted or deposited p-type silicon region in or on the wafer.

The perovskite layer 25 of the front photovoltaic cell 1F is provided with a thickness of 300 - 1000 nm and may have been obtained by thermal evaporation or solution processing or a combination thereof. The electrode 21 is provided as an ITO-layer having a thickness in the order of typically 80 - 90 nm, and 22 as an ZnO:Al (abbreviated as AZO) layer of thickness in the order of 80 - 90 nm. While the acceptable thickness range of layer 21 is giving by anti-reflective properties, the acceptable thickness range of layer 22 can, in principle, be much wider, like 50-200nm. Also the recombination layer 26 is provided as an ITO-layer, however, with a smaller thickness, i.e. in the range of 1-30 nm. The charge carrier transport layer 27 is a hole transport layer that is provided as a pair of sublayers including a first sublayer 271 of sputtered NiO having a thickness of 3-30 nm on the surface of the recombination layer 26 and a second sublayer 272 formed by a self-assembled monolayer having a thickness of 1-50 nm obtained with a solution process using (4-(3,6-Dimethyl-9H-carbazol-9-yl)butyl)phosphonic acid (Me-4PACz). It is convention to refer to a layer of this material as SAM even if it has in reality a thickness larger than a monolayer. The SAM layer 272 provides for a better work function alignment with the neighboring layers. The charge carrier transport layer 24F at the other side of the absorber layer 25 of the front photovoltaic cell 1F is an electron transport layer of SnO2 having a thickness in the range of 3-50 nm, obtained by atomic layer deposition (ALD-SnO2). As noted, the layer 24R has substantially the same thickness and composition and serves as a moisture protection layer for the second electrode 22.

In this more detailed example the electron transport layer 24F is part of an electron transport layer stack. The electron transport layer stack further comprises an electron transport layer 251 of fullerene (C60) with a thickness in the range of 1-50 nm and an interlayer 252 of LiF with a thickness of 1-10 nm.

The metallization grid lines 215, 225 are 5-50μm thick, 20-200 μm wide "digits" of Ag, which can be screen printed from a thick film paste.

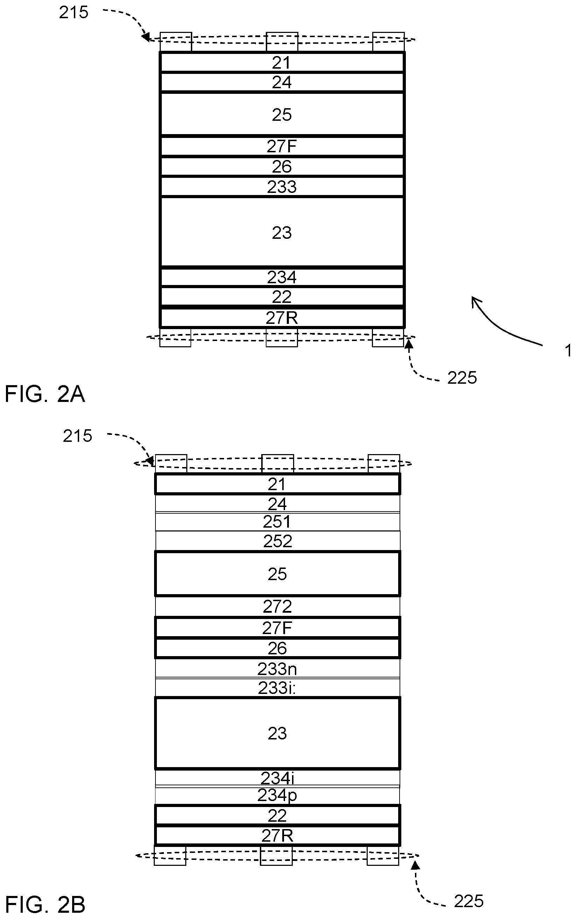

FIG. 2A shows an alternative embodiment of the improved tandem solar cell 1. Parts thereof corresponding to those in FIG. 1A are indicated with the same reference number. The alternative embodiment of the improved tandem solar cell 1 shown in FIG. 2A differs from the version in FIG. 1A in that the second electrode 22 is protected covered by a moisture protection layer 27R having substantially the same thickness and composition as the hole transport layer 27F. It noted that 27F may be one layer in a layer stack that functions as a whole as a charge carrier transport layer. FIG. 2B shows a more detailed example of the alternative embodiment of FIG. 2A. In this example the layer 27R and the hole transport layer 27F substantially have the same thickness, i.e. their thicknesses do not deviate more than 10% from an average value of their thicknesses wherein the average value is selected from a range of 3-50 nm. Also their composition is at least substantially the same, in that in this example both are formed of the material NiO, which typically has been deposited in a bilateral ALD process. In this example the electron transport layer 24 can be obtained by a sputtering process of SnO2, and have a thickness of 5-50 nm. In the example shown in FIG. 2B, further a solution processed self assembling monolayer 272 having a thickness in the range of 1 - 50 nm is provided between the hole transport layer 27F and the perovskite layer 25. The substance (4-(3,6-Dimethyl-9H-carbazol-9-yl)butyl)phosphonic acid (Me-4PACz) was used for the solution based process. The layer 27F deposited in the bilateral deposition process therewith forms part of a stack with the self assembling monolayer 272 so as to act together as hole transport layer. Since the moisture protection functionality of NiO may not be as strong as that of SnO2, in this case layer 22 may consist of ITO.

The first and the second heterojunction 233 and 234 may be provided as in the examples of FIG. 1B and 2B.

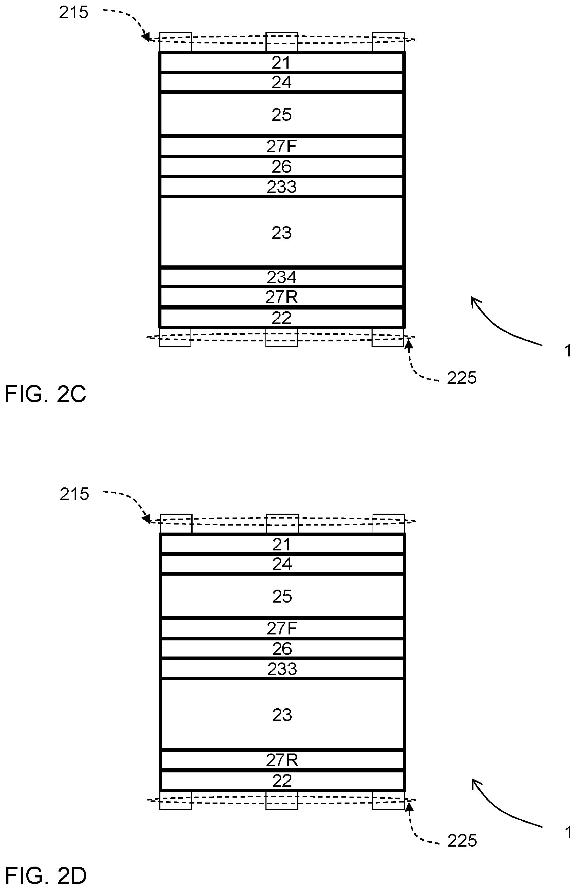

FIG. 2C shows an alternative embodiment. Parts therein corresponding to those in FIG. 2A have the same reference. As shown in FIG. 2C, in this alternative embodiment the layer 27R having substantially the same thickness and composition as the hole transport layer 27F is arranged between the second electrode 22 and the second silicon heterojunction 234. In this embodiment the duplicate layer 27R can enhance the performance of the second silicon heterojunction 234, or even replace the second silicon heterojunction 234 as shown in FIG. 2D. Nevertheless it is preferred to maintain an intrinsic sublayer 234i of H-enriched amorphous (a-Si:H) for better performance. In case instead of a silicon heterojunction a different type of passivated contact is used, which uses a thin dielectric buffer layer, it is preferred to maintain the thin dielectric buffer layer between the substrate and layer 27R for better performance. In case instead of a silicon heterojunction a diffused or implanted or deposited doped silicon region in or on the wafer is used, it is preferred to apply a thin dielectric buffer layer between this doped silicon region and layer 27R.

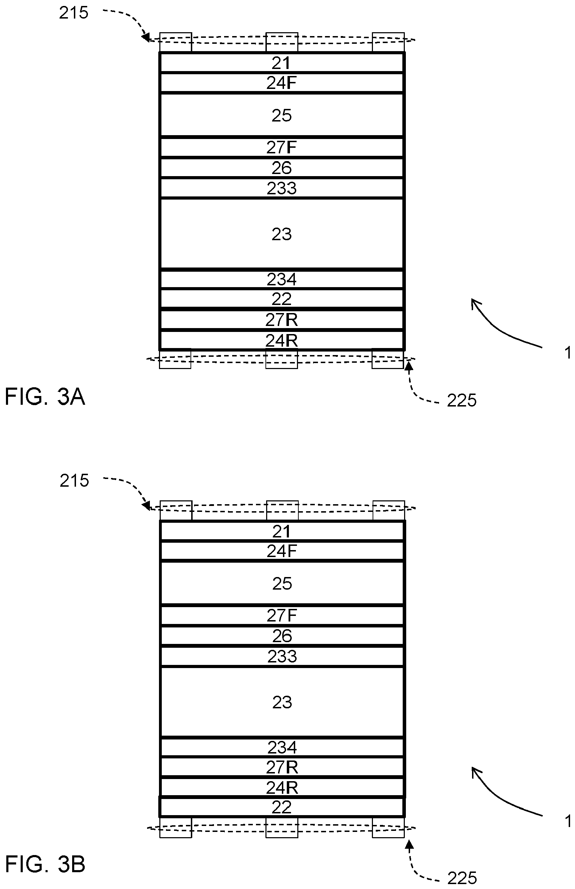

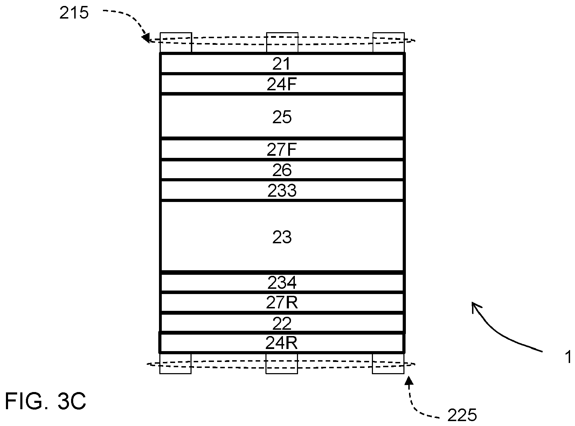

FIG. 3A, 3B and 3C show examples of alternative embodiments of the improved tandem solar cell 1 having more than one pair of duplicate layers. FIG. 3A shows an example wherein the rear electrode 22 is protected by a duplicate version 24R of the electron transport layer 24F. I.e. as in the embodiment of FIG. 1A the rear electrode 22 is protected by a moisture protection layer 24R having substantially the same thickness and composition as the electron transport layer 24F. I.e. their thicknesses do not deviate more than 10% from an average value of their thicknesses wherein the average value is selected from a range of 3-50 nm. Also their composition is at least substantially the same. For example both are formed of the material SnO2, which typically has been deposited in a bilateral ALD process. Layer 27R has substantially the same thickness and composition as the hole transport layer 27F. I.e. their thicknesses do not deviate more than 10% from an average value of their thicknesses wherein the average value is selected from a range of 3-50 nm. Also their composition is at least substantially the same. For example both are formed of the material NiO, which typically has been deposited in a bilateral ALD process.

FIG. 3B differs from the embodiment in FIG. 3A in that the two duplicate layers 27R and 24R are arranged between the substrate 23 and the rear electrode 22. Similar to embodiment 2C, in this embodiment the duplicate layer 27R can enhance the performance of the second silicon heterojunction 234, or even replace the second silicon heterojunction 234. Nevertheless it is preferred to maintain an intrinsic sublayer 234i of H-enriched amorphous (a-Si:H) for better performance. In case instead of a silicon heterojunction a different type of passivated contact is used, which uses a thin dielectric buffer layer, it is preferred to maintain the thin dielectric buffer layer for better performance. In case instead of a silicon heterojunction a diffused or implanted or deposited doped silicon region in or on the wafer is used, it is preferred to apply a thin dielectric buffer layer between this doped silicon region and layer 27R.

In the embodiment of FIG. 3C one duplicate layer 27R is arranged between the substrate 23 and the rear electrode 22 to enhance the performance of the bottom cell, and the other duplicate layer 24R is provided as a protection layer for the rear electrode 22.

As noted above, in practice a charge carrier transport layer, e.g. 24F, 27F may be provided as a member of a charge carrier transport layer stack. A charge carrier transport layer stack comprises one or more additional layers that do not necessarily have a duplicate layer at the opposite side of the substrate. A charge carrier transport layer stack for example includes one or more additional layers to improve band alignment with neighboring layers, to improve mutual adhesion or for the purpose of planarization and the like. In order to more clearly show aspects that are typical for the various embodiments and taking into account that such additional layers, although useful, are not essential for the present invention are not always included.

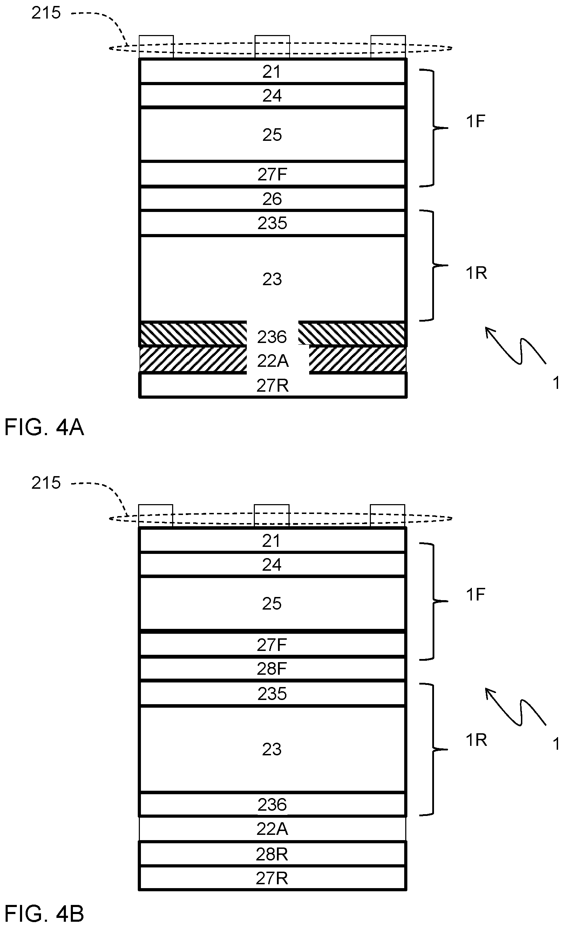

FIG. 4A and 4B show alternative embodiments wherein the rear photovoltaic cell 1R is of a PERC type, this abbreviation denoting "Passivated Emitter and Rear Cell" or alternatively "Passivated Emitter and Rear Contact". The emitter 235 is for example an oxide/polysilicon stack or an n-type diffused surface layer in the wafer optionally forming part of a stack with a thin silicon oxide buffer layer and AZO layer for passivation. The rear photovoltaic cell 1R further has an array of p-type local back surface field (BSF) contacts 236. The second electrode is formed by a metallization layer 22A.

The embodiment of FIG. 4B differs from the embodiment of FIG. 4A in that it comprises a pair of additional n-type ALD layers 28F and 28R. The layer 28F passivates the diffused PERC emitter 235 and forms an effective recombination junction pair with the p-type layer 27F which replaces the recombination layer 26. The duplicate layer 27R forms an additional layer at the side of the metallization layer 22A.

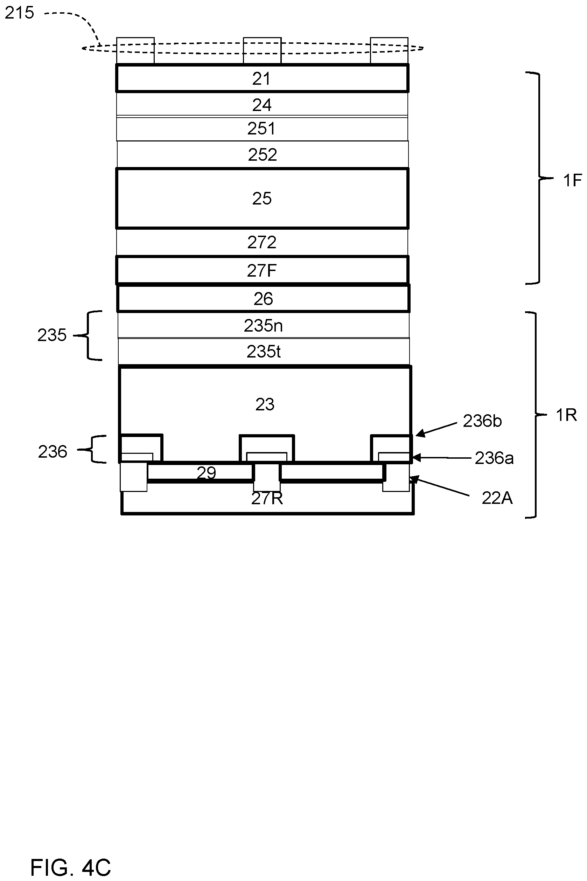

FIG. 4C shows a more detailed implementation of the embodiment of FIG. 4A. Differences with the detailed embodiment of FIG. 2A are as follows. As shown in FIG. 4C, the PERC emitter 235 comprises an n-type polysilicon layer 235n having a thickness in the range of 5-100 nm and between the layer 235n and the silicon wafer an ultrathin (1-3 nm) silicon oxide buffer layer 235t.

As in the embodiment of FIG. 2A, the embodiment of FIG. 4C, comprises a duplicate 27R of the hole transport layer 27F as a layer on the metallization layer 22A.

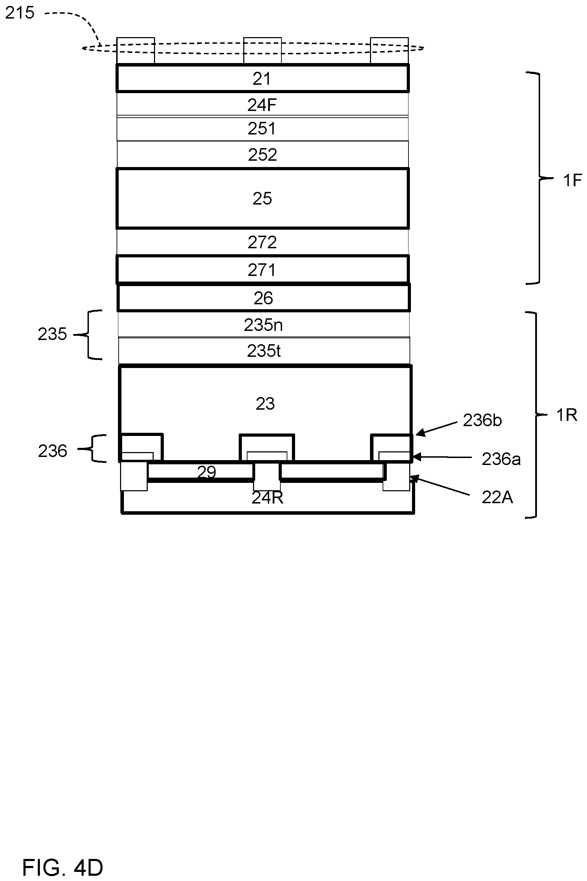

FIG. 4D shows an exemplary embodiment in detail wherein the upper part comprising the front photovoltaic cell 1F corresponds to the front photovoltaic cell 1F of the embodiment shown in FIG. 1B. The rear photovoltaic cell 1R substantially corresponds to that of the embodiment of FIG. 4C, except that here the duplicate layer 24R of the electron transport layer 24F is provided as a protective layer for the rear side of the tandem solar cell 1.

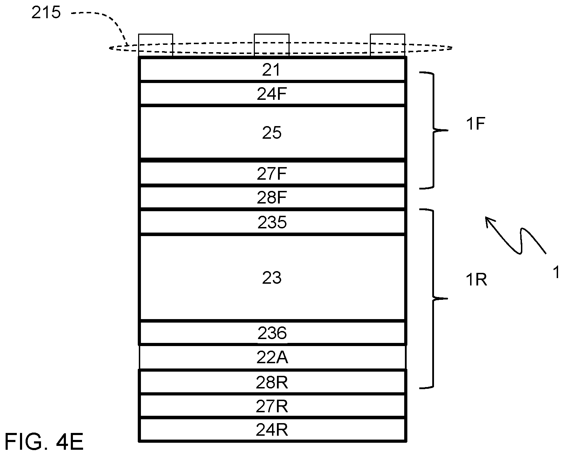

FIG. 4E shows a still further embodiment. Elements therein corresponding to those of FIG. 4B have the same reference number. The embodiment of FIG. 4E differs from that of FIG. 4B in that additionally the electron transport layer 24F has a duplicate 24R which serves as an additional protection layer for the rear side of the tandem solar cell 1. The duplicate layer 24R has substantially the same thickness and composition as the electron transport layer 24F. In an example the electron transport layer 24F and the duplicate layer 24R are simultaneously formed in a bilateral ALD deposition process. For example the pair of layers is formed of SnO2.

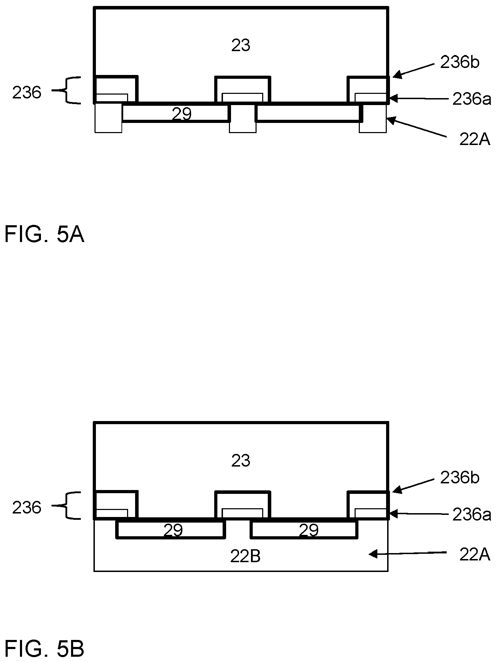

FIG. 5A and 5B show a portion of the rear side 236 and 22A of the PERC type photovoltaic cells from Fig. 4, in two variations. On the rear side the silicon substrate 23 has a dielectric passivating coating 29, which typically comprises a stack of (~5-10nm) AlOx and (~60-150 nm) SiNx. A metallization electrode 22 is formed by an electrically conducting plane or by electrically conducting digits, for example of Al, that provide an electric contact with the wafer 23 via the local back surface field contacts 236 through interruptions (holes) in the dielectric passivating coating 29. In the example shown in Fig. 5A the electrode 22 is formed by digits which are screen printed from a thick film paste and have a thickness and a width in the order of 5-100 $\mu$m and 50-500 $\mu$m respectively, resulting in a bifacial solar cell. The local back surface field contacts 236 comprise a first layer 236a of an Al-Si alloy and a second layer 236b of an Al-doped p+ silicon region that forms a local BSF (LBSF).This variation of the rear side contact is denoted as "bifacial". FIG. 5B shows another variation, denoted as "monofacial" wherein an electrically conducting layer 22B covers substantially completely the dielectric passivating coating 29. The electrically conducting layer 22B makes contact to local contact points 236a/b through interruptions (holes) in the dielectric. 22A and 22B may for example be composed of Al and may be obtained by screen printing a thick film paste.

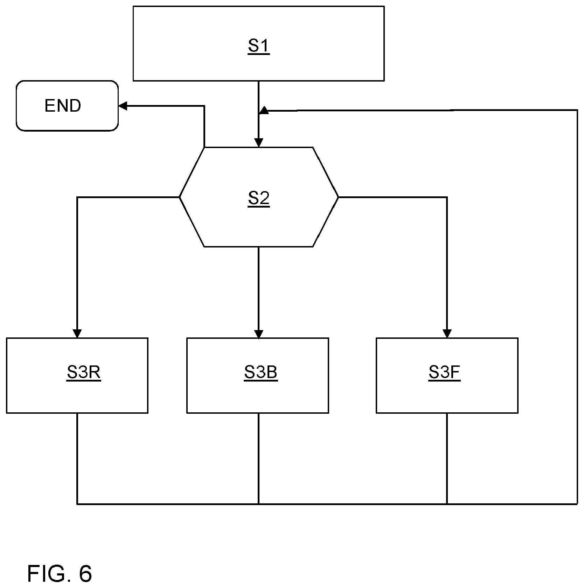

FIG. 6 schematically shows an embodiment of a method according to the present invention for manufacturing a tandem solar cell 1 comprising a stack of at least a rear photovoltaic cell 1R and a front photovoltaic cell 1F between a front electrode 21 facing a light entry window 211 and a rear electrode. The tandem solar cell to be manufactured is configured to perform a photovoltaic conversion of light received through the light entry window 211 to provide an output voltage between the electrodes. Therewith the front photovoltaic cell 1F is configured to convert a first portion of the received light and the rear photovoltaic cell 1R is configured to convert a second portion of the received light that is transmitted by the front photovoltaic cell 1F. The stack of the tandem solar cell to be manufactured includes a substrate 23 with a first side facing the light entry window 211 and a second side facing away from the light entry window. The method comprises providing S1 the substrate and depositing S3R, S3B, S3F functional layers on the substrate. S3R denotes a deposition step at the rear side of the substrate, i.e. at the side of the substrate 23 that is determined to face away from the light entry side 211 in the final product 1. S3F denotes a deposition step at the front side of the substrate, i.e. opposite the rear side. S3B denotes a bilateral deposition step S3B wherein a substance is simultaneously deposited at both sides of the substrate. The improved method comprising at least one bilateral deposition step S3B. In step S2 a process controller determines whether the manufacturing process is finished (END) or which type of deposition step is to be performed next. In addition to the deposition steps S3, other steps may be executed as known in the art, such as thermal treatment, plasma treatment, etching treatments, treatments in solution, treatment in certain ambient gasses, treatment with light, etc.

As an example, the manufacturing process is described for the exemplary product of FIG. 1B. It is presumed that the substrate with which the procedure starts in step S1 is already provided with the layers 233i, 233n, 234i and 234p.

| Step | method | Layer(s) | material | thickness |
|------|--------|----------|----------|-----------|
| S3F | Sputtering | 26 | ITO | 1-30 nm |
| S3F | sputtering | 271 | NiO | 3-30 nm |
| S3F | Solution processing SAM | 272 | Me-4PACz | 1-50 nm |
| S3F | Thermal evaporation / solution processing | 25 | perovskite | 300-1000 nm |
| S3F | Thermal evaporation | 252 | LiF | 1-10 nm |
| S3F | Thermal evaporation | 251 | C60 | 1-50 nm |
| S3R | Sputtering | 22 | AZO | 80-90 nm |

(continued)

| Step | method | Layer(s) | material | thickness |
|------|--------|----------|----------|-----------|
| S3B | ALD | 24F + 24R | SnO2 | 3-50 nm |
| S3F | Sputtering | 21 | ITO | 80-90 nm |
| S3F | Screen printing | 215 | Ag | 5-50 μm |
| S3R | Screen printing | 225 | Ag | 5-50 μm |

Variations of this deposition order are possible, provided that the various layers appear in the proper order on the substrate 23. For example sputtering the layer 22 in a step S3R may take place at any time before the bilateral deposition step S3B is performed wherein the layers 24F, 24R are deposited.

As another example, the manufacturing process is described for the exemplary product of FIG. 2C. Again it is presumed that the substrate with which the procedure starts in step S1 is already provided with the layers 233i, 233n, 234i and 234p.

| Step | method | Layer(s) | material | thickness |
|------|--------|----------|----------|-----------|
| S3F | sputtering | 26 | ITO | 1-30 nm |
| S3B | ALD | 27F + 27R | NiO | 5-50 nm |
| S3F | Solution processing SAM | 28 | Me-4PACz | 1-50 nm |
| S3F | Thermal evaporation or Solution processing | 25 | perovskite | 300-1000 nm |
| S3F | Thermal evaporation | 252 | LiF | 1-10 nm |
| S3F | Thermal evaporation | 251 | C60 | 1-50 nm |
| S3F | Sputtering | 24 | SnO2 | 5-50 nm |
| S3F | Sputtering | 21 | ITO | 80-90 nm |
| S3R | Sputtering | 22 | ITO | 80-90 nm |
| S3F | Screen printing | 215 | Ag | 5-50 μm |
| S3B | Screen printing | 225 | Ag | 5-50 μm |

Also in this example variations in depositing order are possible, provided that the various layers appear in the order as shown in FIG. 2C.

As a further example, the manufacturing process is described for the exemplary product of FIG. 4D. It is presumed that the substrate with which the procedure starts in step S1 is already provided with the layers 235t, 235n, and the rear contact structure as shown in FIG. 5A or 5B.

| Step | method | Layer(s) | material | thickness |
|------|--------|----------|----------|-----------|
| S3F | Sputtering | 26 | ITO | 1-30 nm |
| S3F | Sputtering | 271 | NiO | 5-50 nm |
| S3F | Solution process SAM | 272 | Me-4PACz | 1-50 nm |
| S3F | Thermal evaporation or Solution processing | 25 | perovskite | 300-1000 nm |
| S3F | Thermal evaporation | 252 | LiF | 1-10 nm |
| S3F | Thermal evaporation | 251 | C60 | 1-50 nm |
| S3B | ALD | 24F + 24R | SnO2 | 5-50 nm |
| S3F | sputtering | 21 | ITO | 80-90 nm |
| S3F | Screen printing | 215 | Ag | 5-50 μm |

In other embodiments of the invention, the polarities of charge extraction layers such as heterojunctions, passivated contacts, emitters, etc., etc., may be inverted for both the rear photovoltaic cell and the front photovoltaic cell, to result in a tandem cell of inverted front and rear polarity compared to the examples given earlier. Specifically, the bottom cell may have a rear side n-type contact in combination with a front side p-type contact, in combination with the top cell having a rear side n-type contact and front side p-type contact. Such a tandem cell design can as well benefit from the invention. For example the rear side of the bottom cell may have a i/n silicon heterojunction contact and a front side a i/p silicon heterojunction contact, or the rear side of the bottom cell may have a thin oxide/n-type polysilicon passivated contact and a front side thin oxide/p-type polysilicon contact. Other contact layers for the bottom cell, e.g. diffusions in the substrate such as described in the context of Fig. 1B may also be used, for front and/or rear side of the rear cell, in this configuration of inverted polarity. For the front cell in this case the polarities of the charge carrier transport layers or layer stacks also have to be inverted, i.e., for example the rear side of the front cell could have an electron transport layer including SnO2, and the front side of the front cell could have a hole transport layer including NiO. The additional charge carrier transport layers such as 251,252, 272 would be exchanged accordingly from front side to rear side of the front photovoltaic cell and vice versa, i.e., the LiF and C60 layers would move with the SnO2 layer to the rear side of the front cell (LiF closest to the perovskite layer, SnO2 furthest, and C60 in-between), and the SAM layer would move with the NiO to the front side of the front cell (the SAM closest to the perovskite layer). Materials with a similar functionality of selective carrier extraction and passivation could be used instead of these examples for 251, 252, 272, for example Poly[bis(4-phenyl)(2,4,6-trimethylphenyl)amine (PTAA) on the perovskite layer instead of a SAM, or a PCBM ([6,6]-phenyl-C61-butyric acid methyl ester) layer directly on SnO2 instead of C60/LiF, or a SAM layer instead of LiF on C60 (with the C60 layer on SnO2).

As examples for the embodiments with inverted polarities, if the inversion is applied to Fig. 2B, the rear side electrode of the bottom cell would be protected by SnO2 (layer 27F and 27R would become SnO2 in this inversion, and layer 24 would become NiO). Or if the inversion is applied to Fig. 2C or Fig. 2D, the n-type carrier extraction from the rear side of the bottom cell could be improved by layer 27R being for example SnO2 or AZO. When layer 234 is a diffused layer in the silicon substrate 23, it may enhance cell efficiency if between this diffused layer and layer 27R there is a thin passivating buffer layer, like a 1-5 nm thick dielectric layer like an oxide or nitride, or a 1-10 nm thick intrinsic hydrogenated amorphous silicon layer.

The PERC configuration for a silicon bottom cell is not amenable to such a polarity inversion due to the nature of the PERC rear side contact being based on Al-based local BSF contacts, which cannot be converted to n-type contacts in a straightforward way. However, inversion of polarities of a PERC cell is possible by replacing the Al-based local BSF contacts by e.g. a diffused layer of p-type polarity in the silicon substrate, which would then result in a cell equivalent to one of the examples for Fig. 1.

The manufacturing processes as listed earlier in table format will then similarly be modified to result in a cell structure with inverted polarities. This means the deposition processes for electron transport layers and for hole transport layers exchange place in the table to result in the suitable order of layers.

In the above descriptions, when a material is described with a certain stoichiometry, such as TiO2, it should be understood that deviations of this stoichiometry may occur, and additions of other elements may be present, such as e.g. hydrogen, carbon, metal elements. For example, deviations of stoichiometry or these additions of other elements may act as necessary doping.

In the claims the word "comprising" does not exclude other elements or steps, and the indefinite article "a" or "an" does not exclude a plurality. A single component or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A method (See FIG. 6) of manufacturing a tandem solar cell (1, see e.g. FIG. 1A, 1B etc) comprising a stack of at least a rear photovoltaic component (1R) and a front photovoltaic component (1F) between a front electrode (215) facing a light entry window (211) and a rear electrode (225), the tandem solar cell (1) being configured to perform a photovoltaic conversion of light received through the light entry window (211) to provide an output voltage between the electrodes, the front photovoltaic component (1F) being configured to convert a first portion of the received light and the rear photovoltaic component (1R) being configured to convert a second portion of the received light that is transmitted by the front photovoltaic component (1F), the stack including a substrate (23) with a first side (231) facing the light entry window (211) and a second side (232) facing away from the light entry window (211), the method comprising:

providing (S1) the substrate (23);
depositing (S3R, S3B, S3F) functional layers on the substrate (23);

the method comprises one or more bilateral deposition steps (S3B) wherein a substance is simultaneously deposited at both sides of the substrate.

2. The method according to claim 1, wherein the substance being deposited in a bilateral deposition step of the one or more bilateral deposition steps forms at the front side of the substrate (23) a layer (24F, 27F, 28F) having a selective charge carrier transport functionality.

3. The method according to claim 2, wherein the layer (24F, 27F, 28F) having a selective charge carrier transport functionality comprises a hole transport material having:

i) a valence band edge position relative to vacuum level similar to the valence band edge relative to vacuum level of the absorber material of the photovoltaic cell (e.g. aligning within better than 0.35 eV, preferably better than 0.2 eV);
ii) a wide optical band gap such as 2eV or more (preferably more than 2.5 eV, or even more than 3 eV);
iii) a Fermi level close to the valence band edge, or

the layer (24F, 27F, 28F) having a selective charge carrier transport functionality comprises a hole transport material having:

i) a conductance band edge position relative to vacuum level similar to the valence band edge relative to vacuum level of the absorber material of the photovoltaic cell;
ii) a wide optical band gap such as 2eV or more (preferably more than 2.5 eV, or even more than 3 eV);
iii) a Fermi level close to the conductance band edge, or

the layer (24F, 27F, 28F) having a selective charge carrier transport functionality comprises an electron transport material having:

i) a conductance band edge position relative to vacuum level (electron affinity) similar to the conductance band edge relative to vacuum level of the absorber material of the photovoltaic cell (e.g. aligning within better than 0.35 eV, preferably better than 0.2 eV);
ii) a wide optical band gap such as 2eV or more (preferably more than 2.5 eV, or even more than 3 eV);
iii) a Fermi level close to the conductance band edge.

4. The method according to claim 2 or 3, wherein the layer (24F, 27F, 28F) having a selective charge carrier transport functionality is a hole transport layer primarily comprising NiO, Cu2O, MoO3, WO3, V2O3, or SnO ; or wherein the hole transport layer is deposited using primarily CuO as a precursor; or wherein the layer (24F, 27F, 28F) having a selective charge carrier transport functionality is an electron transport layer primarily comprising SnO2, ZnO, TiO2, Ta2O5, Nb2O5, TiN, TaNx, In2S3, or MoS2.

5. The method according to any of the preceding claims, wherein the substance being deposited in a bilateral deposition step of the one or more bilateral deposition steps forms at the rear side of the substrate a layer (24R, 27R, 28R) covering at least part of the rear electrode (22, 22A).

6. The method according to claim 2, wherein the layer (27R) that is simultaneously deposited with the selective charge carrier transport layer (27F) is provided between the substrate and the rear electrode (22).

7. The method according to any of the preceding claims, wherein the at least one bilateral deposition step (S3B) is an atomic layer deposition process .

8. A tandem solar cell (1) comprising a stack of at least a rear photovoltaic component (1R) and a front photovoltaic component (1F) between a front electrode (215) facing a light entry window (211) and a rear electrode (225), the tandem solar cell (1) being configured to perform a photovoltaic conversion of light received through the light entry window (211) to provide an output voltage between the electrodes (215, 225), the front photovoltaic component (1F) being configured to convert a first portion of the received light and the rear photovoltaic component (1R) being configured to convert a second portion of the received light that is transmitted by the front photovoltaic component (1F), the stack including a substrate (23) with a first side facing (231) the light entry window and a second side (232) facing away from the light entry window (211), **characterized in that** the tandem solar cell (1) comprises one or more pairs of layers, each of said one or more pairs of layers comprising a respective front side layer at a side of the substrate facing the light entry window (211) and a respective rear side layer at a side of the substrate facing away from the light entry window (211), which respective layers of a pair have substantially the same composition.

9. The tandem solar cell (1) according to claim 8, wherein the one or more pairs of layers at least comprise a pair of layers of which the respective front side layer at a side of the substrate facing the light entry window (211) and the respective rear side layer at a side of the substrate facing away from the light entry window (211) have substantially the same thickness.

10. The tandem solar cell (1) according to claim 8 or 9, wherein the front side layer is a selective charge carrier transport layer (24F, 27F).

11. The tandem solar cell (1) according to claim 10 wherein the layer having a selective charge carrier transport functionality comprises a hole transport material having:

   i) a valence band edge position relative to vacuum level similar to the valence band edge relative to vacuum level of the absorber material of the photovoltaic cell (e.g. aligning within better than 0.35 eV, preferably better than 0.2 eV);
   ii) a wide optical band gap such as 2eV or more (preferably more than 2.5 eV, or even more than 3 eV);
   iii) a Fermi level close to the valence band edge, or

   the layer (24F, 27F, 28F) having a selective charge carrier transport functionality comprises a hole transport material having:

   i) a conductance band edge position relative to vacuum level similar to the valence band edge relative to vacuum level of the absorber material of the photovoltaic cell;
   ii) a wide optical band gap such as 2eV or more (preferably more than 2.5 eV, or even more than 3 eV);
   iii) a Fermi level close to the conductance band edge, or

   the layer (24F, 27F, 28F) having a selective charge carrier transport functionality comprises an electron transport material having:

   i) a conductance band edge position relative to vacuum level (electron affinity) similar to the conductance band edge relative to vacuum level of the absorber material of the photovoltaic cell (e.g. aligning within better than 0.35 eV, preferably better than 0.2 eV);
   ii) a wide optical band gap such as 2eV or more (preferably more than 2.5 eV, or even more than 3 eV);
   iii) a Fermi level close to the conductance band edge.

12. The tandem solar cell according to any of the claims 8-11, wherein the layer (24F, 27F, 28F) having a selective charge carrier transport functionality is a hole transport layer primarily comprising $NiO$, $Cu_2O$, $MoO_3$, $WO_3$, $V_2O_3$, or $SnO$; or wherein the layer (24F, 27F, 28F) having a selective charge carrier transport functionality is an electron transport layer primarily comprising $SnO_2$, $ZnO$, $TiO_2$, $Ta_2O_5$, $Nb_2O_5$, $TiN$, $TaN_x$, $In_2S_3$, or $MoS_2$.

13. The tandem solar cell (1) according to one of the claims 8 to 12, wherein the rear side layer (24R, 27R) is arranged between the substrate (23) and the rear electrode (22).

14. The tandem solar cell (1) according to one of the claims 8 to 12, wherein the rear electrode (22) is arranged between the substrate (23) and the rear side layer (24R, 27R).

FIG. 1A

FIG. 1B

FIG. 2A

FIG. 2B

215

| 21 |
| 24 |
| 25 |
| 27F |
| 26 |
| 233 |
| 23 |
| 234 |
| 27R |
| 22 |

1

225

FIG. 2C

215

| 21 |
| 24 |
| 25 |
| 27F |
| 26 |
| 233 |
| 23 |
| 27R |
| 22 |

1

225

FIG. 2D

215

| 21 |
| 24F |
| 25 |
| 27F |
| 26 |
| 233 |
| 23 |
| 234 |
| 22 |
| 27R |
| 24R |

225

1

FIG. 3A

215

| 21 |
| 24F |
| 25 |
| 27F |
| 26 |
| 233 |
| 23 |
| 234 |
| 27R |
| 24R |
| 22 |

1

225

FIG. 3B

FIG. 3C

FIG. 4A

FIG. 4B

FIG. 4C

215

| 21 |
| 24F |
| 251 |
| 252 |
| 25 |
| 272 |
| 271 |
| 26 |

1F

235 {
| 235n |
| 235t |

23

236 {

29

24R

236b

236a

22A

1R

FIG. 4D

215

| 21 |
| 24F |
| 25 |
| 27F |
| 28F |
| 235 |
| 23 |
| 236 |
| 22A |
| 28R |
| 27R |
| 24R |

1F

1R

1

FIG. 4E

FIG. 5A

FIG. 5B

S1

END

S2

S3R

S3B

S3F

FIG. 6

Europäisches
Patentamt
European
Patent Office
Office européen
des brevets

**Application Number**

**EP 23 16 9898**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2019/050185 A1 (LG ELECTRONICS INC [KR]) 14 March 2019 (2019-03-14) * paragraph [0053] - paragraph [0054]; figures 4-14 * * paragraph [0212] - paragraph [0215] * | 1-14 | INV. H01L31/18 H01L31/078 |
| X | WO 2004/084282 A1 (MIDWEST RESEARCH INST [US]; YOUNG DAVID L [US]; NOUFI ROMMEL [US]) 30 September 2004 (2004-09-30) * abstract; figures 1, 2 * | 1,2 | |
| X | WO 2020/204823 A1 (NAT UNIV SINGAPORE) 8 October 2020 (2020-10-08) * abstract; figures 1-4 * | 1,2 | |
| A | WO 2016/085044 A1 (KOREA ENERGY RESEARCH INST [KR]) 2 June 2016 (2016-06-02) * the whole document * | 1-14 | |

**TECHNICAL FIELDS SEARCHED (IPC)**

H01L
H10K

The present search report has been drawn up for all claims

| Place of search | Date of completion of the search | Examiner |
|---|---|---|
| Berlin | 29 September 2023 | Le Meur, M |

## ANNEX TO THE EUROPEAN SEARCH REPORT
## ON EUROPEAN PATENT APPLICATION NO.

EP 23 16 9898

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2023

| Patent document cited in search report | | Publication date | Patent family member(s) | | Publication date |
|---|---|---|---|---|---|
| WO 2019050185 | A1 | 14-03-2019 | NONE | | |
| WO 2004084282 | A1 | 30-09-2004 | AU | 2003220253 A1 | 11-10-2004 |
| | | | WO | 2004084282 A1 | 30-09-2004 |
| WO 2020204823 | A1 | 08-10-2020 | CN | 113875025 A | 31-12-2021 |
| | | | WO | 2020204823 A1 | 08-10-2020 |
| WO 2016085044 | A1 | 02-06-2016 | KR | 101626929 B1 | 02-06-2016 |
| | | | WO | 2016085044 A1 | 02-06-2016 |

EPO FORM P0459

For more details about this annex : see Official Journal of the European Patent Office, No. 12/82